# EUROPEAN PATENT APPLICATION

(11) **EP 4 826 395 A1**
(43) Date of publication of application: **21.10.2026**
(21) Application number: 26167212.5
(22) Date of filing: 24.03.2026
(51) Int. Cl.: G01R 19/04, G01R 19/25

(54) **SINUSOIDAL SIGNAL AMPLITUDE MEASUREMENT CIRCUIT**

(30) Priority: 17.04.2025 IN 202541037343
(71) Applicant: NXP USA, Inc, Austin, TX 78735 (US)
(72) Inventor: Sahu, Siyaram, 5656AG Eindhoven (NL); Sinha, Anand Kumar, 5656AG Eindhoven (NL); Omer, Ateet, 5656AG Eindhoven (NL); Kumar, Atul, 5656AG Eindhoven (NL); Thakur, Akshay, 5656AG Eindhoven (NL)
(74) Representative: Schwarzweller, Thomas

(57) **Abstract**

A comparator has a first input to receive an input voltage level and a second input to receive an input sinusoidal signal. A logic circuit uses the comparator during a first cycle of the input sinusoidal signal to determine a first duration based on a comparison between the input sinusoidal signal and a first voltage level. The logic circuit uses the comparator during a second cycle of the input sinusoidal signal, different from the first cycle, to determine a second duration based on a comparison between the input sinusoidal signal and a second voltage level. A common mode voltage of the input sinusoidal signal is located between the first and second voltage levels. Both the first and second durations are used to calculated an amplitude of the input sinusoidal signal.

## Description

### Background

### Field

This disclosure relates generally to integrated circuits, and more specifically, to a sinusoidal amplitude measurement circuit.

### Related Art

Integrated circuits are designed to generate a sinusoidal signal from a sinusoidal oscillator or resonator to create an accurate timing clock. The quality and reliability of the clock depends on the amplitude of the generated sinusoidal signal. Typically, the amplitude of a crystal oscillator's generated sinusoidal signal is characterized with an external tester by probing the pads of the crystal oscillator. However, for an accurate measurement, the probe must adhere to stringent probing requirements (such as a high resistance and low capacitance). Therefore, since probing impedance typically prevents accurate measurements, a need exists for a measurement circuit which eliminates the need for probing and provides accurate amplitude measurements.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in block diagram form, a pair of identical comparators, each configured to receive the same sinusoidal wave, in accordance with an embodiment of the present invention.
FIG. 2 illustrates waveforms corresponding to a sinusoidal wave provided to the comparators of FIG. 1, and comparator outputs from the comparators of FIG. 1, in accordance with an embodiment of the present invention.
FIG. 3 illustrates, in block diagram form, a measurement circuit using the comparators of FIG. 1, in accordance with one embodiment of the present invention.
FIGs. 4-6 illustrate, in block diagram form, measurement circuits using time multiplexing, in accordance with various embodiments of the present invention.
FIG. 7 illustrates, in partial schematic and partial block diagram form, a more detailed implementation of the measurement circuit of FIG. 6, in accordance with an embodiment of the present invention.
FIG. 8 illustrates waveforms corresponding to various signals of the measurement circuit of FIG. 7, in accordance with an embodiment of the present invention.
FIG. 9 illustrates, in flow diagram form, a method of operating the measurement circuit of FIG. 7, in accordance to an embodiment of the present invention.

### Detailed Description

An on-chip measurement circuit is capable of measuring the amplitude of a sinusoidal signal with the use of a comparator. In one aspect, a sinusoidal signal is provided to a comparator to obtain various count values over multiple cycles, which can be used by a digital circuit to obtain an accurate amplitude measurement. By using a single comparator over multiple cycles with different inputs, the effects of comparator offset can be minimized. In this manner, the on-chip measurement circuit does not require external test equipment or probing, in which probes introduce problematic impedance affecting a crystal oscillator's performance. Therefore, unlike probing, the on-chip measurement circuit determines an accurate amplitude measurement without hindering the generation of a correct sinusoidal signal amplitude. Further, the on-chip measurement circuit can be used to provide built-in self-testing (BIST) of the crystal oscillator, and can be enabled during a self test phase of a system-on-chip (SoC). With the ability to be used during BIST, the on-chip measurement circuit can also be used to analyze ageing of a crystal oscillator.

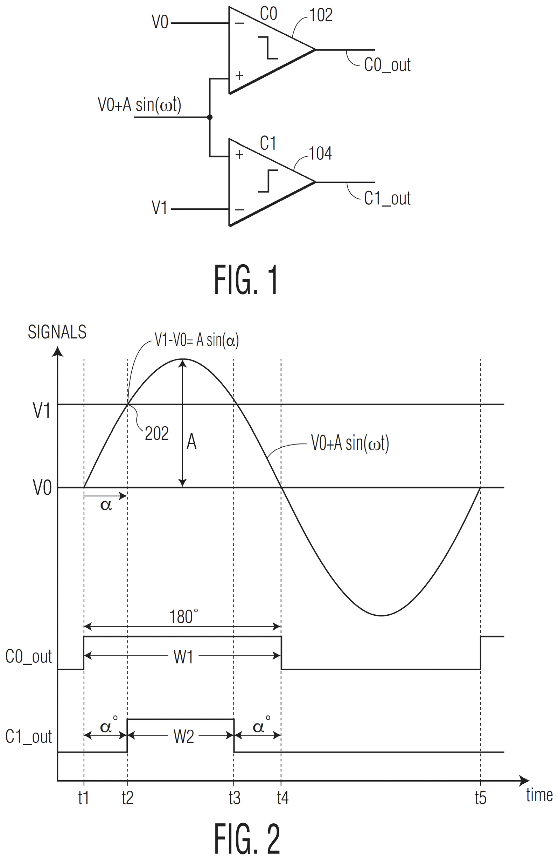

FIG. 1 illustrates, in schematic form, a pair of identical analog comparators C0 102 and C1 104, each configured to receive the same input sinusoidal (sine) wave signal, represented as V0+Asin(ωt), and FIG. 2 illustrates waveforms corresponding to the input sine wave signal provided to comparators C0 102 and C1 104, and the corresponding outputs of C0102 and C1 104, C0_out and C1_out, respectively, in accordance with an embodiment of the present invention. As illustrated in FIG. 1, the input sine wave signal (also referred to simply as the input sine wave or the input sine signal) is fed into the non-inverting inputs of each of C0 102 and C1 104. The input sine wave can be generated by any oscillator circuit, such as, e.g., a crystal oscillator circuit, in which the crystal is located off-chip. FIG. 2 illustrates the input sine wave, V=V0+A sin(ωt) in which "V0" represents the offset or common mode voltage, "A" represents the amplitude of the sin wave, and "ω" the angular frequency. Assuming V0 is 0V and V1 is an arbitrary voltage level at which the sine wave has an angle of alpha (α) from its initial position, then V1 (at point 202) can be represented as A·sin(α). Therefore, if V1 and angle α is known, the amplitude A can be calculated. Similarly, referring to FIG. 2, if V0 is not zero, then V1 (at point 202) can be represented as V0+A·sin(α).

As illustrated in FIG. 2, the input sin wave is provided to the non-inverting (i.e. positive) inputs of C0 102 and C1 104, while V0 is provided to the inverting (i.e. negative) input of C0 102 and V1 is provided to the inverting input of C1 104. Therefore, C0_out has a rising edge to a logic level high (e.g. logic level one) at time t1, when V begins to rise over V0 such that V>V0. C1_out remains at a logic level low (e.g. logic level zero) until V reaches V1 at time t2. While V remains above V0, C0_out remains at a logic level high, and while V remains above V1, C1_out remains at a logic level high. Therefore, C1_out has a falling edge at time t3 when V again falls below V1, and C0_out has a falling edge at time t4 when V falls below V0. If it is assumed that there are no offsets in comparators C0 and C1, then the pulse width W1 of C0_out between times t1 and t4 corresponds to the first half cycle of the input sin wave (which corresponds to 180°). Also, in this first half cycle, the time between the rising edges of C0_out and C1_out, and likewise the time between the falling edges of C1_out and C0_out, each corresponds to α°. Therefore, the pulse width W2 of C1_out between times t2 and t3 corresponds to "W1 - (2·α°)" which equals "180° - (2·α°)". From this relationship, the value of α° can be represented based on a ratio of W2 to W1, as follows:${α}^{∘} = \left(1-\left(W2/W1\right)\right) \times \left({180}^{∘}/2\right)$ Eq. 1

The value of A can therefore be calculated as follows:$A = \left(V1-V0\right) / sin \left({α}^{∘}\right)$ Eq. 2

Therefore, it can be seen that the amplitude of the input sine wave depends on the difference "V1-V0" and the ratio of W2 to W1. The values of W1 and W2, and thus their ratio, can each be determined with one or more counters, in which the counters have a much higher frequency as compared to the input sine wave.

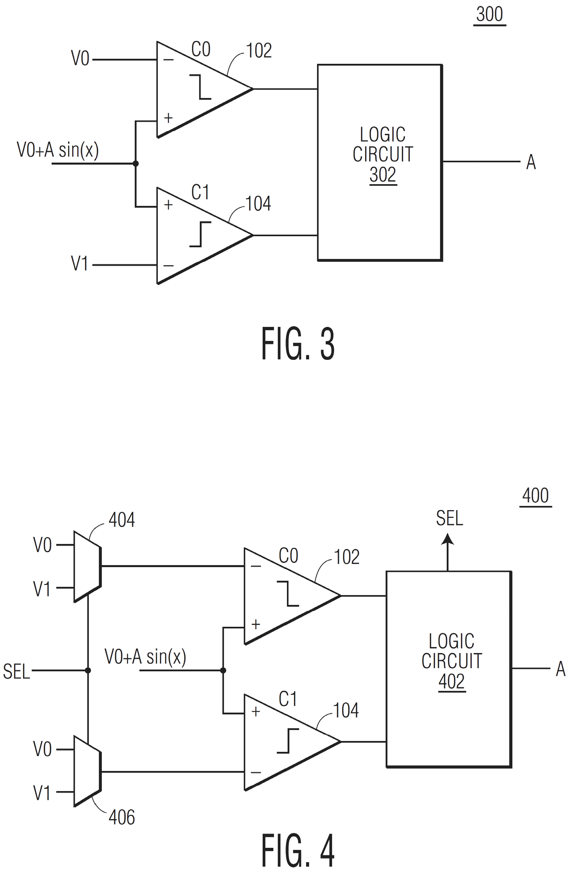

FIG. 3 illustrates, in block diagram form, a measurement circuit 300 which includes comparators C0 102 and C1 104 of FIG. 1 and a logic circuit 302 to provide the measured amplitude A, in accordance with one embodiment of the present invention. Logic circuit 302 may include a first counter to determine W1 in which C0_out can be used as an input to the first counter to start and stop (i.e. enable and disable) the counter and a second counter to determine W2 in which C1_out can be used as an input to the second counter to start and stop (i.e. enable and disable) the counter. The resulting count values of the first and second counters (CV1 and CV2, respectively) would therefore represent the values of W1 and W2, respectively, and can be used to determined the ratio W2/W1 as CV2/CV1. Logic circuit 302 may include additional circuitry to then complete the calculation of A using the determined ratio as well as the known values of V1 and V0.

FIGs. 4-6 illustrate, in block diagram form, measurement circuits using time multiplexing, in accordance with various embodiments of the present invention. In the examples above, it is assumed that comparators C0 and C1 include no offset. However, such analog comparators do typically include an offset, therefore, time multiplexing over multiple cycles can be used, along with additional multiplexers (MUXes, also referred to as voltage selector circuits), to process one voltage at a time to help reduce the effect of the comparator offset.

For example, FIG. 4 illustrates a measurement circuit 400 which includes C0 102 and C1 104, each coupled to receive the input sine wave at the non-inverting inputs, along with a logic circuit 402 and MUXes 404 and 406. MUX 404 is configured to receive V0 at a first input and V1 at a second input, in which an output of MUX 404 is coupled to the inverting input of C0 102. MUX 406 is configured to receive V0 at a first input and V1 at a second input, in which an output of MUX 406 is coupled to the inverting input of C1 104. Each of MUXes 404 and 406 receive a select signal, SEL, at a control input, in which the SEL signal can be generated by logic circuit 402 to toggle after each full cycle of the input sine wave. In one embodiment, over a first half of a first cycle of the input sine wave, SEL can be set to select V0 to be provided at the outputs of MUX 404 and MUX 406, in which counters in logic circuit 402 can operate as described above in reference to FIG. 3 to determine values of W1. In this case, one counter can determine W1 based on C0_out and another counter can determine W1 based on C1_out. Then, over a first half of a subsequent second cycle the input sine wave, SEL can be toggled so as to select V1 to be provided at the outputs of MUX 404 and MUX 406, in which the counters in logic circuit 402 can then determine values of W2, in which one counter determines W2 based on C0_out and the other based on C1_out. The values of W1 from the first cycle can be combined (e.g. added) and the values of W2 from the second cycle can be combined (e.g. added), and the ratio of W2 to W1 can be determined using the combined values determined over the two cycles of the input sine wave. In this manner, the effect of the offsets of the comparators can be reduced.

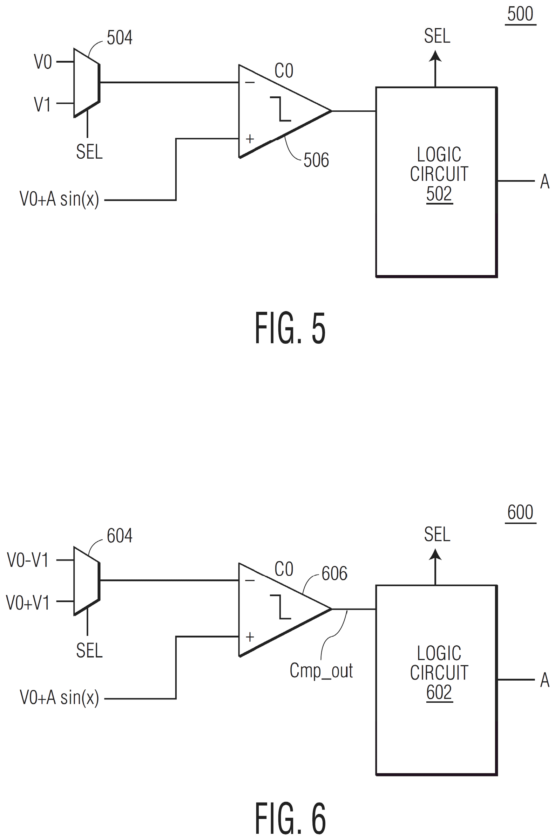

As another example, FIG. 5 illustrates a measurement circuit 500 which includes a comparator C0 506 (which can be the same type of analog comparator as C0 102), a MUX 504, and a logic circuit 502. In the illustrated embodiment of FIG. 5, MUX 504 receives V0 at a first input and V1 at a second input, and provides an output to an inverting input of C0 506. The input sine wave is provided to the non-inverting input of C0 506. As was described above with respect to logic circuit 402, logic circuit 502 can provide SEL to the control input of MUX 506 such that, for the first half of a first cycle of the input sine wave, V0 is provided to C0 506 so that W1 can be measured by logic circuit 502. Then, for a first half of a subsequent second cycle, logic circuit 502 can provide SEL such that V1 is provided to C0 506 so that W2 can be measured by logic circuit 502. In this manner, both W1 and W2 are measured using the same single comparator, C0 506, such that, in determining the ratio between W1 and W2, the offset effects of comparator C0 506 can be reduced.

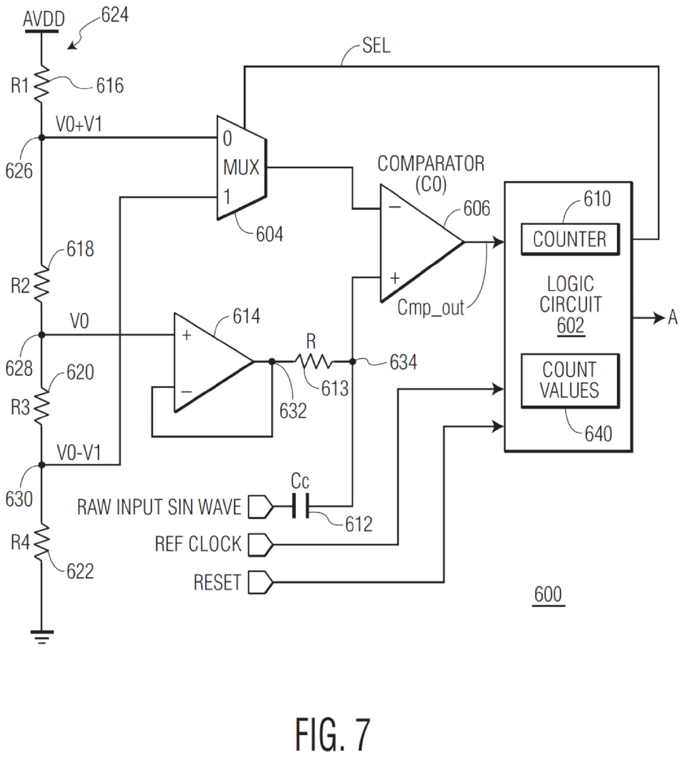

FIG. 6 illustrates another example of time multiplexing over multiple cycles in which a measurement circuit 600 which includes a comparator C0 606 (which can be the same type of analog comparator as C0 102 or C0 506), a MUX 604, and a logic circuit 602, in accordance with one embodiment of the present invention. In the illustrated embodiment, MUX 604 is coupled to receive V0-V1 at a first input and V0+V1 at a second input, in which one of these is provided, based on the value of SEL from logic circuit 602, as an input voltage level to an inverting input of C0 606. An output of C0 606 (referred to as cmp_out) is provided to logic circuit 602. The input sine wave is provided to a non-inverting input of C0 606. Logic circuit 602 controls SEL to select V0-V1 and V0+V1 as needed, to obtain measurements to determine the ratio of W2 to W1, while reducing the effects of any comparator offset of C0 606. Measurement circuit 600 will be described in more detail below in reference to FIGs. 7, 8, and 9.

FIG. 7 illustrates, in partial block diagram and partial schematic form, a more detailed implementation of measurement circuit 600, in accordance with an embodiment of the present invention. Measurement circuit 600 further includes a buffered amplifier 614 and a voltage divider 624. Voltage divider 624 is configured to provide V0+V1 to the fist input of MUX 604, V0-V1 to the second input of MUX 604, and V0 to a first (non-inverting) input of amplifier 614. In the illustrated embodiment, voltage divider 624 includes series-connected resistors R1 616, R2 618, R3 620, and R4 622. A first terminal of R1 is coupled to a first voltages supply terminal configured to provide a first supply voltage, AVDD, and a second terminal of R1 is coupled to a circuit node 626. A first terminal of R2 is coupled to node 626, and a second terminal of R2 is coupled to a circuit node 628. A first terminal of R3 is coupled to node 628, and a second terminal of R3 is coupled to a circuit node 630. A first terminal of R4 is coupled to node 630, and a second terminal of R4 is coupled to a second voltage supply terminal configured to provide a second supply voltage, GND (e.g. 0V). In the illustrated embodiment, R1 and R4 have a same resistance value, and R2 and R3 have a same resistance value, such that node 626 provides V0+V1, node 628 provides V0 (as AVDD/2), and node 630 provides V0-V1. Therefore, note that the values of V0 and V1 are known values. Note also that in alternate embodiments, different circuitry can be used to generate or provide V0+V1, V0, and V0-V1.

In the illustrated embodiment, measurement circuit 600 also includes a capacitive element Cc 612 and a resistor R 613. An output of amplifier 614 is coupled to a circuit node 632 and to a second (inverting) input of amplifier 614. A first terminal of R 613 is coupled to node 632, and a second terminal of R 613 is coupled to a circuit node 634. A raw (e.g. unfiltered) input sine wave is coupled via Cc 612 to node 634, in which node 634 is coupled to the non-inverting input of C0 606. In operation, Cc 612 filters (i.e. removes) the offset from the raw input sine wave, while buffered amplifier 614 (implemented as a unity gain buffer) provides V0 to node 634 so as to add back the offset V0 into the filtered raw input sine wave at the second terminal of Cc 612. Therefore, node 634 provides a reconstructed input sine wave (based on the filtered raw input sine wave and V0) as V=V0+Asin(ωt) to the non-inverting input of C0 606 (analogous to the input sine wave provided to the non-inverting inputs of C0 102 and C1 104 of FIG. 1).

Logic circuit 602 provides SEL to MUX 604 in which SEL is set to a logic level low for at least a first cycle of the input sine wave so as to select V0+V1 to provide to C0 606, and then toggled to a logic level high during a second subsequent cycle of the input sine wave so as to select V0-V1 to provide to C0 606. Logic circuit 602 receives a reference clock (which is a high frequency clock as compared to the input sine wave) and a reset signal. Logic circuit 602 includes a counter 610 which is used to provide count values based on the reference clock and the output of C0 606. Logic circuit 602 also includes storage circuitry 640 configured to store count values from counter 610, as needed. For example, as will be described below, during the first cycle of the input sine wave, counter 610 provides two count values, count1 followed by count2, in which, for count1, counter 610 counts the number of pulses of the reference clock between successive edges of cmp _out (e.g. from a rising edge to a subsequent falling edge of cmp_out). For count2, counter 610 counts the number of pulses of the reference clock between next successive edges of cmp _out (e.g. from the falling edge to the subsequent rising edge of cmp _out). Then, during the second cycle of the input sine wave, counter 610 provides a third count value, count3, in which counter 610 again counts the number of pulses of the reference clock between successive edges of cmp _out (e.g. from a falling edge to a subsequent rising edge of cmp_out). Note that counting pulses of the reference clock can be done by counting active edges of the reference clock, which may refer to either rising or falling edges, depending on the implementation of counter 610. All count values can then be stored in storage circuitry 640. After all three count values are obtained, the values can be processed to obtain the ratio of W2 to W1 and thus the amplitude of the input sine wave can be calculated.

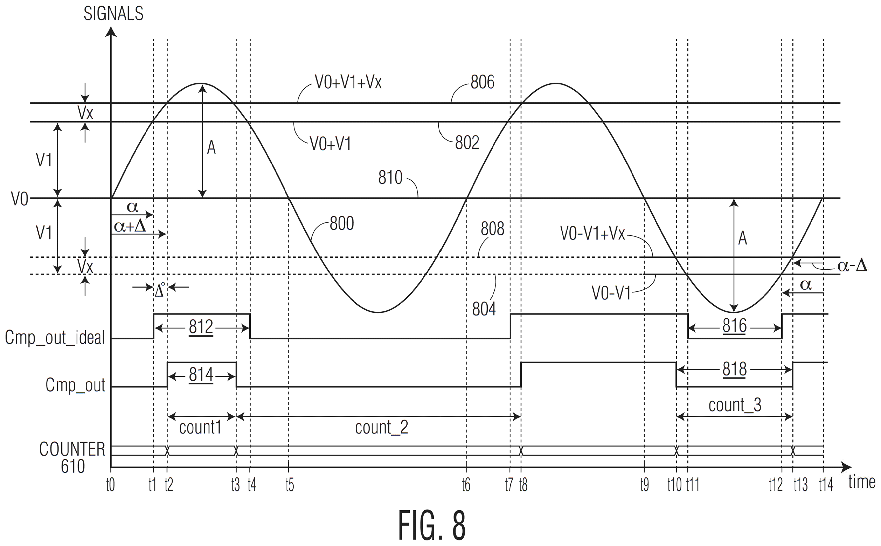

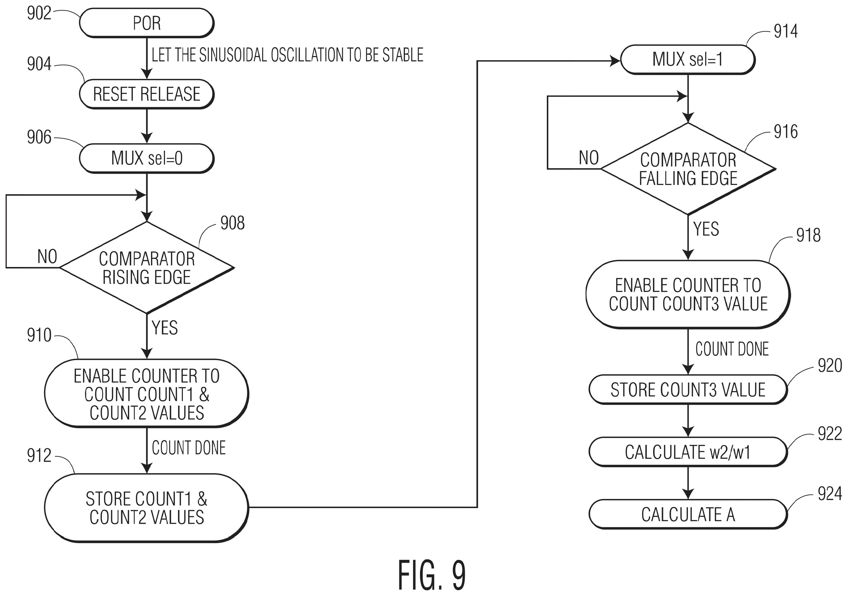

Operation of measurement circuit 600 will be described in reference to the waveforms of FIG. 8 and the flow diagram of FIG. 9. FIG. 8 illustrates the waveform for input sine wave (V) 800 (which is the same as the input sine wave described in FIG. 2 above, but FIG. 8 illustrates two cycles of input sine wave 800), the output of C0 606 if there were no offset in the comparator (cmp_out_ideal), and the output of C0 606 assuming there is an offset of Vx in the comparator (cmp_out). FIG. 9 illustrates a method 900 of operating measurement circuit 600, in accordance with an embodiment of the present invention.

Referring to FIG. 8, FIG. 8 illustrates a voltage level 810 which corresponds to the common mode voltage V0, a voltage level 802 which corresponds to V0+V1, and a voltage level 804 which corresponds to V0-V1. The levels 802 and 804 are the voltage levels used to illustrate the generation of cmp_out_ideal. However, if it is assumed that C0 606 introduces an offset of Vx, then voltage level 802 is effectively offset to voltage level 806 which corresponds to V0+V1+Vx, and the voltage level 804 is effectively offset to voltage level 808 which corresponds to V0-V1+Vx. In this case, the levels 806 and 808 are used to illustrate the generation of cmp _out (which differs from cmp_out_ideal due to the comparator offset).

For example, in the first cycle of the input sine wave (time t0 - t6), without an offset in the comparator, cmp_out_ideal is at a logic level high while V0+V1 is greater than V, resulting in a positive pulse (i.e. a pulse at a logic level one) between times t1 and t4, having a pulse width (PW) 812, which is similar to W2 described above with respect to FIGs. 1 and 2. However, with an offset in the comparator, when V0+V1 is compared to V, the resulting angle α at V0+V1 is shifted to α+Δ, therefore, cmp_out does not go to a logic level high until time t2 (after time t1), and cmp_out returns to a logic level zero sooner, at time t3 (prior to time t4), therefore resulting in a positive pulse between times t2 and t3, having a PW 814 which is shorter than PW 812 by Δ° at each side of PW 814 (corresponding to t1 - t2 and t3 - t4, thus shortening PW 812 by "2 x Δ°").

Similarly, for the second cycle of the input sine wave (time t6-t14), V0-V1 is selected for comparison to V at some point prior to the second half of the second cycle (time t9 - t14), in which cmp_out_ideal transitions to a logic level one (because at this point V is greater than V0-V1). Without an offset in the comparator, once V falls and reaches V0-V1, cmp_out_ideal is negated to a logic level zero (at time t11) and remains at logic level zero while V is below V0-V1, and returns to a logic level one once V again reaches V0-V1 (at time t12). This results in a negative pulse (i.e. a pulse at a logic level zero) between times t11 and t12, having a PW 816. However, with an offset in the comparator, the resulting α at V0-V1 is shifted to α-Δ, therefore, for the second half of the second cycle, cmp_out transitions back to a logic level zero sooner (at time t10 rather than t11) and remains at a logic level zero until time t13 (after time t12), therefore resulting in a negative pulse between t10 and t13, having a PW 818 which is longer than PW 812 by Δ° at each side of PW 818 (corresponding to t10 - t11 and t12 - t13, thus lengthening PW 816 by "2 x Δ°").

Assuming that comparator 606 does have the offset Vx, counter 610 is used in the first cycle of the input sine wave to determine PW 814 (as count1) and is then used to determine the remaining duration of a full cycle (as count2, in which time t2 - t8 represents the duration of a full cycle), and then is used in the second cycle to determine PW 818 (as count3). The use of these count values to determine the ratio of W2 to W1 results in minimizing the effect of Vx on the final amplitude calculation. Note that since each of the count values represent durations of time, they can each be referred to as durations, in which each of the durations is determined based on the comparator output of C0 606. For example, PW 814 (countl) is a duration between successive edges of cmp_out (between a rising edge and immediately following falling edge) during the first half (time t0 - t5) of the first cycle (time t0 - t6) of the input sine wave due to V being detected as crossing V0+V1 (but which actually occurs at V0+V1+Vx due to the offset of C0 606), while PW 818 (count3) is a duration between successive edges of cmp _out (between a falling edge and immediately following rising edge) during the second half (time t9 - t14) of the second cycle (time t6 - t14) of the input sine wave due to V being detected as crossing V0-V1 (but which actually occurs at V0-V1+Vx due to the offset of C0 606). Also, for example, count2 is a duration between successive edges of cmp _out (between a falling edge, which occurs in the first cycle, and an immediately following rising edge, which occurs in the second cycle). Note that, as used herein, a falling edge of a signal and a rising edge of the signal are considered to be opposite type edges of the signal.

Referring back to FIG. 9, method 900 begins with a power-on-reset (POR) 902, in which the input sine wave is given time to settle and be stable, after which, the reset is released at time 904. The reset signal may also be communicated to logic circuit 602 via the reset input so as to reset counter 610. Upon reset, logic circuit 602 sets SEL to a logic level zero (block 906) so as to select V0+V1 as the input to C0 606. Next, at decision diamond 908, logic circuit 602 waits for a comparator rising edge (i.e. until a rising edge in cmp_out occurs which indicates V is greater than V0+V1+Vx). This corresponds to time t2 in which cmp_out goes to a logic level one. At this point (block 910), counter 610 is enabled to start counting active edges of the reference clock. Counter 610 continues to count until the next falling edge of cmp_out (at time t3) in which V falls below V0+V1+Vx. The value of counter 610 at this point corresponds to count1, as labeled in FIG. 8, and represents PW 814.

In one embodiment, in which logic circuit 602 includes only one counter (counter 610), the count value of count1 is noted or stored and counter 610 can continue to count until a next rising edge of cmp_out which occurs at time t8, when V again rises above V0+V1+Vx. In this case, the final count value of counter 610 corresponds to count1 + count2, which corresponds to a full cycle of V. The value of count2 can therefore be determined by subtracting count1 from the final count value. (Note that in the case of no comparator offset, this next rising edge of the comparator output, cmp_out_ideal, occurs at time t7 rather than t8.) In another embodiment, counter 610 can be reset when the falling edge of cmp_out occurs at time t3 so as to directly provide count2 at time t8. In yet another embodiment, multiple counters can be used in which a first counter is used for count1 and a second counter is used for count2. The values of count1 and count2 are stored (block 912 of FIG. 9) within storage circuitry 640 of logic circuit 602 (in which they can be stored when both counts are done, or count1 can be stored prior to completing count2).

Once count2 is obtained, logic circuit 602 toggles SEL (block 914) at time t8 so as to select V0-V1 to be provided to C0 606. Also, since count2 has been obtained and saved, counter 610 can be reset (e.g. reset to zero). Upon setting SEL to a logic level one to select V0-V1, cmp_out transitions to a logic level one because V is greater than V0-V1. Note that SEL should be toggled to a logic level one at least prior to the start (e.g. at time t9) of the second half of the second cycle (time t9 - t14) of the input sine wave to ensure that cmp_out transitions to a logic level one before C0 606 detects that V drops below V0-V1, in order to create the negative pulse. Referring back to FIG. 9, at decision diamond 916, logic circuit 602 waits for a comparator falling edge (i.e. until a falling edge in cmp_out occurs to indicate V is less than V0-V1+Vx). This corresponds to time t10, when V falls bellow V0-V1+Vx and cmp_out transitions to a logic level zero. This falling edge can enable counter 610 (block 918) to again start counting active edges of the reference clock. At time t13, cmp_out transitions back to a logic level one (since V again rises above V0-V1+Vx), in which this rising edge can stop counter 610 to obtain count3. Then, at block 920, count3 can be stored in storage circuitry 640 as well.

Next, at blocks 922 and 924 of method 900, the ratio of W2 to W1 is calculated and the amplitude of the input sine wave is calculated, respectively. Note that since there is an offset in the comparator (corresponding to Vx), the change in the count1 value from the ideal case (e.g. a reduction by Δ, between t1 and t2 and between t3 and t4) is recovered with the count3 value which also changes from the ideal case (e.g. an increase by Δ, between t10 and t11 and between t12 and t13). In this case, the ratio of W2 and W1 is determined using a whole cycle of input sine wave, equivalent to 360°. The whole cycle of 360° is provided by "count1+count2" which corresponds to 2*W1 (in which W1 of FIG. 3 corresponds to only 180°). The value of "count1+count3" corresponds to 2*W2 (in which count1 corresponds to W2 of FIG. 3 of the first half of the first cycle of the input sine wave and count3 corresponds to W2 of FIG. 3, but as measured in the second half of the second cycle of the input sine wave). Therefore, the final ratio is provided by:$W 2 / W 1 = \left(count1+count3\right) / \left(count1 + count2\right)$ Eq. 3

The value of α° can be calculated using W2/W1, as described with Eq. 1 above. Then, since V1 and V0 are known, and now α° is known, Eq. 2 can be used to accurately calculate the amplitude, A. Logic circuit 602 can include any type of digital circuitry, as known in the art, to calculate W2/W1 in accordance with Eq. 3 and α° in accordance with Eq. 1 in order to calculate A in accordance with Eq. 2. The calculation of A does not affect the input sinusoidal signal, and further, minimizes the effect of any offset of the comparator.

Note that, in alternate embodiments, additional counters (in addition to counter 610) and comparators can be used within logic circuit 602 to determine the count values. For example, there can be one counter for each count value. In this case, all of the count values may be determined within a single cycle of the input sine wave rather than two cycles. For example, while counter 610 can be used to determine count1 and count2, a separate comparator and counter can be used to determine count3. However, with the use of a single comparator, such as C0 606, the multiple count values determined based on the output of the single comparator helps minimum the offset.

Also, in alternate embodiments, additional logic may be used to handle different polarities of the signals. For example, counter 610 to can be enabled/disabled (e.g. start/stop counting) based on either a rising or falling edge of a control input. Therefore, if cmp _out is used as the control input to enable or disable counting, it may be possible to add logic to invert cmp_out while SEL is at a logic level one so as to produce a positive pulse for PW 818 rather than a negative pulse. Also, during the first cycle and then during the second cycle, when counter 610 is enabled to count between successive edges, the first edge of the successive edges can either be a rising or falling edge, while the other of the successive edges can be the opposite edge (i.e. the other of the rising or falling edge). In other embodiments, other types of digital logic can be used to obtain the required count values based on cmp_out. Similarly, the inverting/non-inverting inputs of the comparators and amplifiers can be swapped, as needed, based on the desired polarity of the output signals.

Therefore, by now it can be appreciated how a single comparator can be used, over multiple cycles of an input sine wave, to obtain various measurement values, in which the measurement values and other known quantities can be used to measure the amplitude of the input sine wave. In one embodiment, both a common mode voltage of the input signal (e.g. V0) as well as an additional input voltage (e.g. V1) can be provided, in which the measurement values can be used to determine a pulse width ratio of W2 to W1 and the known voltage levels (e.g. V0 and V1) in addition to the pulse width ratio can be used to calculate the amplitude. In this embodiment, the use of the single comparator over multiple cycles allows for improved accuracy by minimizing the effects of any comparator offset. The on-chip measurement circuit can be used for various applications, such as during BIST testing or as needed during an application phase of the SoC. It may also be used as a diagnostic tool which can provide ageing information of a sinusoidal generator (by monitoring amplitude measurements of the input sine wave over time).

The terms "assert" or "set" and "negate" (or "deassert" or "clear") are used herein when referring to the rendering of a signal, status bit, or similar apparatus into its logically true or logically false state, respectively. If the logically true state is a logic level one, the logically false state is a logic level zero. And if the logically true state is a logic level zero, the logically false state is a logic level one.

Each signal described herein may be designed as positive or negative logic, where negative logic can be indicated by a bar over the signal name or an asterisk (*) following the name. In the case of a negative logic signal, the signal is active low where the logically true state corresponds to a logic level zero. In the case of a positive logic signal, the signal is active high where the logically true state corresponds to a logic level one. Note that any of the signals described herein can be designed as either negative or positive logic signals. Therefore, in alternate embodiments, those signals described as positive logic signals may be implemented as negative logic signals, and those signals described as negative logic signals may be implemented as positive logic signals.

Because the apparatus implementing the present invention is, for the most part, composed of electronic components and circuits known to those skilled in the art, circuit details will not be explained in any greater extent than that considered necessary as illustrated above, for the understanding and appreciation of the underlying concepts of the present invention and in order not to obfuscate or distract from the teachings of the present invention.

Although the invention has been described with respect to specific conductivity types or polarity of potentials, skilled artisans appreciated that conductivity types and polarities of potentials may be reversed.

Moreover, the terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Those skilled in the art will recognize that the boundaries between logic blocks are merely illustrative and that alternative embodiments may merge logic blocks or circuit elements or impose an alternate decomposition of functionality upon various logic blocks or circuit elements. Thus, it is to be understood that the architectures depicted herein are merely exemplary, and that in fact many other architectures can be implemented which achieve the same functionality.

Also for example, in one embodiment, the illustrated elements of measurement circuit 600 are circuitry located on a single integrated circuit or within a same device (in which, if the input sine wave is based on a crystal oscillator, the crystal is located external the integrated circuit). Storage circuitry 640 of logic circuit 602 can be implemented with any type of storage circuitry and may be located external to logic circuit 602 and can be located external to measurement circuit 600.

A comparator has a first input to receive an input voltage level and a second input to receive an input sinusoidal signal. A logic circuit uses the comparator during a first cycle of the input sinusoidal signal to determine a first duration based on a comparison between the input sinusoidal signal and a first voltage level. The logic circuit uses the comparator during a second cycle of the input sinusoidal signal, different from the first cycle, to determine a second duration based on a comparison between the input sinusoidal signal and a second voltage level. A common mode voltage of the input sinusoidal signal is located between the first and second voltage levels. Both the first and second durations are used to calculated an amplitude of the input sinusoidal signal.

Furthermore, those skilled in the art will recognize that boundaries between the functionality of the above described operations merely illustrative. The functionality of multiple operations may be combined into a single operation, and/or the functionality of a single operation may be distributed in additional operations. Moreover, alternative embodiments may include multiple instances of a particular operation, and the order of operations may be altered in various other embodiments.

Although the invention is described herein with reference to specific embodiments, various modifications and changes can be made without departing from the scope of the present invention as set forth in the claims below. For example, additional logic processing may be performed on any of the control signals (e.g. the comparator outputs) generated within any of the measurement circuits described above. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

The term "coupled," as used herein, is not intended to be limited to a direct coupling or a mechanical coupling.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

The following are various embodiments of the present invention. Note that any of the aspects below can be used in any combination with each other and with any of the disclosed embodiments.

In an embodiment, an integrated circuit includes a comparator having a first input coupled to receive an input voltage level, a second input coupled to receive an input sinusoidal signal, and an output configured to provide a comparator output; and a logic circuit configured to use the comparator output during a first cycle of the input sinusoidal signal to determine a first duration based on a comparison between the input sinusoidal signal and a first voltage level, use the comparator output during a second cycle of the input sinusoidal signal, different from the first cycle, to determine a second duration based on a comparison between the input sinusoidal signal and a second voltage level, wherein a common mode voltage of the input sinusoidal signal is centered between the first and second voltage levels, and using both the first duration and second duration to calculate an amplitude of the input sinusoidal signal. In one aspect, the logic circuit is further configured to use the comparator output to determine a third duration corresponding to a whole cycle of the input sinusoidal signal. In a further aspect, the logic circuit is further configured to determine a ratio of a sum of the first and second durations to the third duration. In yet a further aspect, the logic circuit is further configured to use the ratio to determine an angle value of the input sine wave corresponding to first voltage level, and calculate the amplitude of the input sinusoidal signal based on the angle value. In another aspect of the above embodiment, the integrated circuit further includes an amplifier having a first input coupled to receive a common voltage level, a second input coupled to an output of the amplifier, wherein the output is coupled to a circuit node; and a capacitive element configured to filter an offset from a received raw input sinusoidal signal and provide the filtered raw input sinusoidal signal to the circuit node, wherein the circuit node is configured to provide a reconstructed input sinusoidal signal based on the filtered raw input sinusoidal signal and the common voltage level as the input sinusoidal signal to the second input of the comparator. In a further aspect, the amplifier is implemented as a unity gain amplifier. In another aspect, the integrated circuit further includes a voltage selector circuit having a first input configured to receive the first voltage level, a second input configured to receive the second voltage level, and an output configured to provide one of the first voltage level or the second voltage level as the input voltage level to the first input of the comparator based on a select signal, wherein the logic circuit is configured to provide the select signal to select the first voltage level prior to determining the first duration, and toggle the select signal to select the second voltage level in the second cycle, prior to determining the second duration. In a further aspect, the integrated circuit further includes a voltage divider configured to generate the first voltage level at a first voltage divider node, the common mode voltage level at a second voltage divider node, and the second voltage level at a third voltage divider node. In yet a further aspect, a resistance between the second voltage divider node and the first voltage divider node equals a resistance between the second voltage divider node and the third voltage divider node, and a resistance between the first voltage divider node and a first voltage supply terminal equals a resistance between the third voltage divider node and a second voltage supply terminal. In another aspect of the above embodiment, the logic circuit further receives a reference clock, wherein the comparator output is configured to control enabling and disabling counting by the counter, and each of the first duration and the second duration correspond to a number of active edges of the reference clock counted by the counter. In another aspect, the first cycle of the input sinusoidal signal immediately precedes the second cycle of the input sinusoidal signal. In yet another aspect, each of the first duration and the second duration are affected by an offset of the comparator.
In another embodiment, a method for calculating amplitude of an input sinusoidal signal includes providing the input sinusoidal signal to a first input of a comparator and a reference voltage level to a second input of the comparator; setting the reference voltage level to a first voltage level; during a first cycle of the input sinusoidal signal, enabling a first counter to determine a first duration between successive edges of the comparator output; after determining the first duration, setting the reference value level to a second voltage level, wherein an a common mode voltage of the input sinusoidal signal is centered between the first and second voltage levels; during a second cycle of the input sinusoidal signal, enabling the first counter to determine a second duration between successive edges of the comparator output; and using the first and second durations to calculate an amplitude of the input sinusoidal signal. In one aspect, during the first cycle, the enabling the first counter to determine the first duration between successive edges of the comparator output includes enabling the first counter to count active edges of a reference clock between a first edge of the comparator output and an immediately following second edge of the comparator output, wherein the first and second edges are opposite type edges. In a further aspect, during the second cycle, the enabling the first counter to determine the second duration between successive edges of the comparator output includes enabling the first counter to count active edges of the reference clock between a third edge of the comparator output and an immediately following fourth edge of the comparator output, wherein the third and fourth edges are opposite type edges. In another aspect of the another embodiment, the method further includes, after determining the first duration, using the first counter to determine a duration of a whole cycle of the input sinusoidal signal. In a further aspect, the using the first counter to determine the duration of the whole cycle of the input sinusoidal signal includes using the first counter to determine a third duration between successive edges of the comparator output wherein a first edge of the successive edges occurs during in the first cycle and an immediately following second edge of the successive edges occurs during the second cycle, wherein the first and second edges are opposite type edges. In another further aspect, the using the first and second durations to calculate the amplitude of the input sinusoidal signal includes determining a ratio of a sum of the first and second durations to the duration of the whole cycle. In a further aspect, the using the first and second durations to calculate the amplitude of the input sinusoidal signal includes determining an angle value of the input sine wave corresponding to first voltage level, and calculating the amplitude of the input sinusoidal signal based on the angle value. In another aspect of the another embodiment, each of the first duration and the second duration are affected by an offset of the comparator.

## Claims

1. An integrated circuit, comprising:
a comparator having a first input coupled to receive an input voltage level, a second input coupled to receive an input sinusoidal signal, and an output configured to provide a comparator output; and
a logic circuit configured to:
use the comparator output during a first cycle of the input sinusoidal signal to determine a first duration based on a comparison between the input sinusoidal signal and a first voltage level,
use the comparator output during a second cycle of the input sinusoidal signal, different from the first cycle, to determine a second duration based on a comparison between the input sinusoidal signal and a second voltage level, wherein a common mode voltage of the input sinusoidal signal is centered between the first and second voltage levels, and
using both the first duration and second duration to calculate an amplitude of the input sinusoidal signal.

2. The integrated circuit of claim 1, wherein the logic circuit is further configured to use the comparator output to determine a third duration corresponding to a whole cycle of the input sinusoidal signal.

3. The integrated circuit of claim 2, wherein the logic circuit is further configured to determine a ratio of a sum of the first and second durations to the third duration.

4. The integrated circuit of claim 3, wherein the logic circuit is further configured to:
use the ratio to determine an angle value of the input sinusoidal signal corresponding to first voltage level, and
calculate the amplitude of the input sinusoidal signal based on the angle value.

5. The integrated circuit of any preceding claim, further comprising:
an amplifier having a first input coupled to receive a common voltage level, a second input coupled to an output of the amplifier, wherein the output is coupled to a circuit node; and
a capacitive element configured to filter an offset from a received raw input sinusoidal signal and provide the filtered raw input sinusoidal signal to the circuit node, wherein the circuit node is configured to provide a reconstructed input sinusoidal signal based on the filtered raw input sinusoidal signal and the common voltage level as the input sinusoidal signal to the second input of the comparator.

6. The integrated circuit of claim 5, wherein the amplifier is implemented as a unity gain amplifier.

7. The integrated circuit of any preceding claim, further comprising:
a voltage selector circuit having a first input configured to receive the first voltage level, a second input configured to receive the second voltage level, and an output configured to provide one of the first voltage level or the second voltage level as the input voltage level to the first input of the comparator based on a select signal, wherein the logic circuit is configured to:
provide the select signal to select the first voltage level prior to determining the first duration, and
toggle the select signal to select the second voltage level in the second cycle, prior to determining the second duration.

8. The integrated circuit of claim 7, further comprising:
a voltage divider configured to generate the first voltage level at a first voltage divider node, the common mode voltage at a second voltage divider node, and the second voltage level at a third voltage divider node.

9. The integrated circuit of claim 8, wherein a resistance between the second voltage divider node and the first voltage divider node equals a resistance between the second voltage divider node and the third voltage divider node, and a resistance between the first voltage divider node and a first voltage supply terminal equals a resistance between the third voltage divider node and a second voltage supply terminal.

10. The integrated circuit of any preceding claim, wherein the logic circuit further receives a reference clock, wherein the comparator output is configured to control enabling and disabling counting by a counter, and each of the first duration and the second duration correspond to a number of active edges of the reference clock counted by the counter.

11. The integrated circuit of any preceding claim, wherein the first cycle of the input sinusoidal signal immediately precedes the second cycle of the input sinusoidal signal.

12. The integrated circuit of any preceding claim , wherein each of the first duration and the second duration are affected by an offset of the comparator.

13. A method for calculating amplitude of an input sinusoidal signal, comprising:
providing the input sinusoidal signal to a first input of a comparator and a reference voltage level to a second input of the comparator;
setting the reference voltage level to a first voltage level;
during a first cycle of the input sinusoidal signal, enabling a first counter to determine a first duration between successive edges of a comparator output of the comparator;
after determining the first duration, setting the reference voltage level to a second voltage level, wherein an a common mode voltage of the input sinusoidal signal is centered between the first and second voltage levels;
during a second cycle of the input sinusoidal signal, enabling the first counter to determine a second duration between successive edges of the comparator output; and
using the first and second durations to calculate an amplitude of the input sinusoidal signal.

14. The method of claim 13, wherein, during the first cycle, the enabling the first counter to determine the first duration between successive edges of the comparator output comprises:
enabling the first counter to count active edges of a reference clock between a first edge of the comparator output and an immediately following second edge of the comparator output, wherein the first and second edges are opposite type edges.

15. The method of claim 14, wherein, during the second cycle, the enabling the first counter to determine the second duration between successive edges of the comparator output comprises:
enabling the first counter to count active edges of the reference clock between a third edge of the comparator output and an immediately following fourth edge of the comparator output, wherein the third and fourth edges are opposite type edges.
